## Europäisches Patentamt
## European Patent Office
## Office européen des brevets

(19)

(11) Veröffentlichungsnummer: **0 111 152**
**A2**

(12) # EUROPÄISCHE PATENTANMELDUNG

(21) Anmeldenummer: 83110975.6

(22) Anmeldetag: 03.11.83

(51) Int. Cl.³: **H 01 L 27/01**

(30) Priorität: 09.11.82 DE 3241225

(43) Veröffentlichungstag der Anmeldung:
20.06.84 Patentblatt 84/25

(84) Benannte Vertragsstaaten:
AT BE CH DE FR GB IT LI LU NL SE

(71) Anmelder: F & O electronic systems GmbH + Co.
Kirchenstrasse 38
D-6901 Neckarsteinach(DE)

(72) Erfinder: Obstfelder, Günther
Panoramastrasse 28
D-6840 Weinheim-Lützelsachsen(DE)

(72) Erfinder: Kreutze, Gerhard
Kirchenstrasse 38
D-6901 Neckarsteinach(DE)

(72) Erfinder: Lüttig, Winfried
Lange Acker 6
D-6901 Heiligkreuzsteinach(DE)

(74) Vertreter: Mierswa, Klaus, Dipl.-Ing.
Tullastrasse 19
D-6800 Mannheim(DE)

(54) **Verfahren zur Herstellung elektronischer Schaltelemente und/oder Schaltungen in Vielschicht-Dickfilmtechnik (Multilayer Thick Film Technology) auf einem Substrat und dergestalt hergestellte Schaltelemente und/oder Schaltungen.**

(57) Die Erfindung betrifft ein Verfahren zur Herstellung elektronischer Schaltelemente und/oder Schaltungen in Vielschicht-Dickfilmtechnik auf einem Substrat. Die elektronischen Schaltelemente und/oder Schaltungen werden in Form von flüssigen oder pastösen Materialien-Mischungen auf das Substrat aufgedruckt und anschließend wärmebehandelt, wonach mindestens eine Isolierschicht auf die Dickfilm-Leiterschicht aufgebracht wird. Dabei werden beliebige Isolier-Zwischenschichten bezüglich ihrer Oberfläche abtragend bearbeitet und anschließend auf diese bearbeitete Oberfläche wiederum mindestens eine Dickfilm-Leiterschicht und/oder mindestens eine Isolierschicht aufgebracht, deren Oberfläche bei weiterfolgenden Druckvorgängen von Dickfilm-Leiterschichten oder bei weiteren Isolierschichten wiederum abtragend bearbeitet wird, um nach Abschluß jeder Schicht mindestens die Weiter- verarbeitungsgrundlagen und -voraussetzungen bezüglich der Oberfläche wie auf der Substratoberfläche zu schaffen.

Die Erfindung betrifft ein Verfahren zur Herstellung elektronischer Schaltelemente und/oder Schaltungen in Vielschicht-Dickfilmtechnik (Multilayer-Thick-Film-Technology) auf einem Substrat, insbesondere Aluminiumocyd oder Prozellan,wobei die elektronischen Schaltelemente und/oder Schaltungen in Form von flüssigen oder pastösen Materialien-mischungen auf das Substrat aufgedruckt und anschließend wärmebehandelt werden (Dickfilm-Leiterschicht) und danach mindestens eine Isolierschicht auf die Dickfilm-Leiterschicht aufgebracht wird. Ebenso betrifft die Erfindung dergestalt hergestellte elektronische Schaltelemente und/oder Schaltungen in Dickfilm-Technik mit sehr hoher Maßhaltigkeit.

Zur Herstellung von elektronischen Schaltelementen und/oder Schaltungen in Dickfilm-Technik ist es bekannt, auf ein Substrat, welches insbesondere aus Aluminiumoxyd oder aus Porzellan besteht, eine Dickfilm-Leiterschicht mittels Raster oder Maskierung und Schablone in Form von flüssigen oder pastösen Materialien-Mischungen auf das Substrat aufzubringen. Anschließend wird das Substrat einer Wärmebehandlung unterzogen, wobei die flüssigen oder pastösen Materialien-Mischungen der Dickfilmschicht aussintern und die darin in pulverisierter Form enthaltenen elektrisch leitenden Stoffe auf dem Substrat in der gewünschten Konfiguration fixiert werden. Anschließend können auf die dergestalt hergestellte Dickfilm-Leiterschicht eine oder mehrere Isolierschichten aufgebracht werden.

Als hier einschlägiger Stand der Technik sei beispielsweise genannt: D.J. Holmes und R.G. Loasby: Handbook of Thick Film Technology, Electrochemical Publications Ltd., Ayr, Scotland, 1976, Bell and Bain Ltd. Glasgow 1976.

Ebenso ist es bekannt, auf diese Weise Thermoplatinen für thermoelektrische Drucker herzustellen, wobei direkt auf das Substrat eine elektrisch leitende Widerstandsschicht in Dickfilm-Technik aufgebracht ist und auf diese wiederum eine Isolierschicht angeordnet ist.

Dabei ist es bekannt, beispielsweise bei der Herstellung von Thermoplatinen die einzelnen Widerstände der Widerstandsschicht zu trimmen, bis der einzelne Widerstand in einem vorgegebenen Toleranzbereich den gewünschten Widerstandswert aufweist. Dabei ist es bis heute nur möglich, den einzelnen Widerstand bezüglich seines Volumens nur durch Veränderung der Oberflächenkonfiguration zu trimmen, was eine Reihe von Nachteilen hat. Durch die Veränderung der druckenden Oberfläche des einzelnen Resistors wird auch das Druckbild im ganzen verändert, und zwar verschlechtert. Daneben ist diese Art und Weise des Trimmens nicht sehr präzise und erfordert relativ große Widerstands-Toleranzbereiche. Die Anwendung des Sandstrahlverfahrens zur Abtragung der Oberfläche ist nur für große Flächen möglich, kann jedoch bei der Herstellung derartiger Widerstände nicht sinnvoll eingesetzt werden. Hinzu kommt, daß in diesem Fall die Ecken gebrochen werden, wodurch das einzelne Schriftbild des Widerstandspunktes unscharf wird.

Ein weiterer Nachteil der bekannten Verfahren zur Herstellung derartiger Dickfilm-Schaltelemente und/oder Schaltungen besteht darin, daß es nicht möglich ist, in genau definierter Maßhaltigkeit auf verschiedenen Ebenen oberhalb des Substrats wieder zu drucken, also auf eine aufgebrachte Isolierschicht wiederum eine Dickfilm-Leiterschicht in Feinlinientechnik aufzubringen. Hier sind bis heute nur sehr grobe Ergebnisse vorhanden, beispielsweise die Anordnung von Leiterbahnen in verschiedenen Ebenen, isoliert voneinander durch Isolierschichten. Es ist jedoch nicht möglich, ein beliebiges Bauelement, beispielsweise einen IC oder einen Resistor, auf eine beliebige Ebene oberhalb des Substrats aufzudrucken.

Werden Hybrid-Schaltungen als Thermoplatinen aufgebaut, so ist jedoch die Notwendigkeit, die Resistorschicht direkt auf das Substrat aufzubringen, ebenfalls nachteilig. Denn die in den Resistoren entwickelte Wärme wird zu einem großen Teil an das Substrat abgegeben und steht deshalb zur eigentlichen Aufgabe, die Bedruckung des Papiers, nicht mehr zur Verfügung. Deshalb benötigen Thermoplatinen des Standes der Technik eine hohe Leistung, um ein einigermaßen befriedigendes Druckbild abzugeben. Ebenso muß die Resistorschicht mit einer

0111152

Isolierschicht vorzugsweise aus Glas überzogen werden, damit die Resistorschicht während des Druckvorganges bei der Anlage des Papiers nicht zu schnell abgenützt wird. Dadurch aber wird die Resistorschicht zum Papier nochmals verschlechtert, weshalb aufgrund der Isolierschicht ebenfalls eine erhöhte Leistung benötigt wird. Zusätzlich wird dadurch ein größerer Anpreßdruck der Thermoplatine an das zu bedruckende Papier benötigt.

Der Erfindung liegt deshalb die Aufgabe zugrunde, die geschilderten Nachteile bei der Herstellung von elektronischen Schaltelementen und/oder Schaltungen in Vielschicht-Dickfilm-Technik zu vermeiden. Insbesondere soll das Herstellungsverfahren dergestalt verbessert werden, daß in allen Ebenen mit hoher Maßhaltigkeit auf nachfolgende Isolierschichten wiederum eine Dickfilm-Leiterschicht aufgedruckt werden kann. Dabei soll in jede beliebige Ebene jede Art von Bauelement auftragbar sein und somit ein Feinliniendruck in allen Ebenen mit hoher Maßhaltigkeit definiert ermöglicht werden.

Diese Aufgabe wird erfindungsgemäß dadurch gelöst, daß eine beliebige Isolier-Zwischenschicht oder beliebige Isolier-Zwischenschichten bezüglich ihrer Oberfläche abtragend bearbeitet werden und anschließend auf diese bearbeitete Oberfläche wiederum mindestens eine Dickfilm-Leiterschicht und/oder mindestens eine Isolier-Schicht aufgebracht wird, deren Oberfläche bei weiterfolgenden Druckvorgängen von Dickfilm-Leiterschichten oder bei weiteren Isolierschichten wiederum abtragend bearbeitet wird, um nach Abschluß jeder Schicht mindestens die Weiterverarbeitungsgrundlagen und -voraussetzungen wie auf dem Substrat zu schaffen.

Weitere Ausführungen der Erfindung sind in den Unteransprüchen gekennzeichnet.

Das erfindungsgemäße Verfahren besitzt gegenüber den bekannten Verfahren des Standes der Technik den Vorteil, daß mit diesem auf die verschiedensten Isolierschichten oberhalb des Substrates wiederum weitere Dickfilm-Leiterschichten aufgedruckt werden können, und zwar in Feinlinientechnik. Es kann somit in vorteilhafter Weise jede beliebige Isolierschicht wiederum als Ausgangsschicht für eine aufzudruckende Dickfilm-Leiterschicht dienen, weil die Isolierschichten wie auch die Dickfilm-Leiterschichten in hoher Maßhaltigkeit, bezogen beispielsweise auf die Oberfläche des Substrats, erfindungsgemäß hergestellt werden. Deshalb ist es aufgrund des erfindungsgemäßen Verfahrens zum ersten Mal möglich, auch auf eine zweite oder dritte oder beliebige Isolierschicht wiederum definiert eine elektronische Schaltung oder ein elektronisches Bauelement aufzudrucken und diese im Herstellungsprozeß mit darunter liegenden Dickfilmschaltungen beliebig zu verbinden und zu kontaktieren. Dadurch können beliebige Hybrid-Schaltungen hergestellt werden, die darüber hinaus eine hohe Konzentration an elektronischen Bauelementen oder elektronischen Schaltungen aufweisen können. Entscheidend ist, daß erfindungsgemäß jede beliebige Isolierschicht dergestalt bearbeitet werden kann, daß sie in Bezug auf die technologischen Daten, wie Oberflächenwelligkeit, Oberflächenrauhigkeit, Maßhaltigkeit, Planität und Planparallelität / die Ausgangseigenschaften des Substrates besitzt oder übertrifft. Nur deshalb ist es möglich, wiederum definiert auf einer Isolierschicht zu drucken. Besitzt eine beliebige Isolierschicht wiederum die Ausgangsdaten desSubstrates, so ist offensichtlich, daß der auf dieser Isolierschicht erfolgende Druck einer Dickfilm-Leiterschicht die gleiche Güte besitzt, wie der Druck direkt auf das Substrat.

Erfindungsgemäß werden die Isolierschichten und ggf. auch die Dickfilm-Leiterschicht in der letzten Lage, abtragend bearbet, und zwar mit höchstmöglicher Maßhaltigkeit und Genauigkeit, so daß die technologischen Daten des Substrates bzw. der Oberfläche des Substrates, wie Planparellität, Oberflächenrauhigkeit, Oberflächenwelligkeit und Abstandsmaße, auf der bearbeiteten Oberfläche der Isolierschicht wieder erreicht und noch übertroffen werden.

Des weiteren eignet sich das erfindungsgemäße Verfahren hervorragend zur Herstellung von Thermoplatinen für thermoelektrische Drucker. Aufgrund der Erfindung, eine beliebige Isolierschicht oberhalb der Substratsoberfläche dergestalt zu bearbeiten, daß diese Oberfläche der Isolierschicht als Ausgangsoberfläche für den Druckvorgang geeignet ist, ist es möglich, die Resistorschicht nicht auf dem Substrat anzuordnen, sondern erst auf verschiedenen, dazwischen liegenden Isolierschichten, wobei die Resistorschicht als oberste letzte Schicht auf den Isolierschichten angeordnet sein kann. In diesem Fall befindet sich somit die Isolierschicht genau an der Stelle, wo sie technologisch gebraucht wird, nämlich direkt am Papier. Das hat den Vorteil, daß als Isolierschichten schlechte Wärmeleiter verwendet werden können, so daß die dem Resistor zugeführte Wärme von diesem nur sehr schlecht an die unter der Widerstandsschicht liegenden Isolierschichten abgeführt, sondern wie gewünscht nach oben an das zu bedruckende Papier abgegeben wird.

Ist das Hybrid-Schaltelement beispielsweise eine Thermodruckplatine, so ist aufgrund der abtragenden Bearbeitung und der dadurch erzielten minimalen Welligkeit der druckenden Oberfläche der Resistoren eine exakte planparallele Anlage der Druckzeile an die Gegendruckeinrichtung, beispielsweise eine Walze, gegeben. Dadurch wird die Resistorschicht nicht ungleichmäßig abgenützt, das Druckbild ist völlig gleichmäßig.

Aufgrund der abtragenden Bearbeitung auf eine definierte Maßhaltigkeit kann des weiteren die Resistor-schicht sehr dünn im Vergleich zu den bekannten Resistorschichten bei bekannten Thermoplatinen gehalten werden. Dadurch wird die Wärmeträgheit der Resistoren erheblich verringert, weshalb die Resistoren mit weniger notwendiger Leistung schneller werden als bekannte Resistoren des Standes der Technik. Das erfindungsgemäße Verfahren ermöglicht somit eine Optimierung der Wärmeträgheit.

Bei der Herstellung von Thermoplatinen besitzt das erfindungsgemäße Verfahren den weiteren Vorteil, daß dieses ein Abgleichen oder Trimmen des Resistors über das Volumen ermöglicht, ohne daß dabei die Flächengeometrie geändert wird. Erfindungsgemäß wird die Dicke der Resistorschicht geändert, die Resistorschicht wird definiert abgetragen. Dadurch entfallen die heute zum Trimmen der Resistoren verwendeten relativ komplizierten Techniken, die ausschließlich die Flächengeometrie des Resistors verändern, nicht aber die Dicke der Resistorschicht. Dadurch wiederum ist es möglich, definierte Resistoroberflächen als entsprechende Druckpunkte herzustellen, um dergestalt ein exaktes Druckbild des einzelnen Resistors zu ermöglichen.

Ein weiterer Vorteil des erfindungsgemäßen Verfahrens bei der Herstellung von Thermoplatinen besteht darin, daß die Resistorschicht beliebig mechanisch bearbeitet werden kann, ohne daß darunter liegende weitere Dickfilmschichten, beispielsweise Leiterbahnen, zerstört oder in Mitleidenschaft gezogen werden. Es können deshalb alle bekannten Abgleichverfahren, wie Sandstrahlen, Laser-Schneidtechnik eingesetzt werden, die man bei den heutigen Thermoplatinen zu Herstellung der einzelnen REsistoren nicht einsetzen kann. Es sind deshalb praktisch alle mechanischen und chemischen Bearbeitungsverfahren der REsistorschicht möglich, weshalb in vorteilhafter Weise eine freie Wahl der geometrischen Anordnung der elektronischen Elemente und/oder Schaltungen auf den verschiedenen Isolierschichten möglich ist. Denn eine Verletzung von

0111152

unter der zu bearbeitenden Dickfilmleiterschicht liegenden leitenden Schichten ist nicht möglich, weil zwischen zwei Dickfilmleiterschichten wiederum beliebig dicke Isolierschichten angeordnet sein können, weshalb eine Beeinträchtigung von darunter liegenden Leiterschichten ausgeschlossen ist.

Deshalb ist es mit dem erfindungsgemäßen Verfahren möglich, im allgemeinen jede beliebige Hybridschaltung in Dickfilmtechnik aufzubauen.

Beim Aufbau von Thermoplatinen für thermoelektrische Drucker können nunmehr auch unter die Resistorschicht eine oder mehrere Schichten angeordnet werden, die die von der Resistorschicht nach unten auf das Substrat hin abgestrahlte Wärmestrahlung wieder zurückwirft, so daß der Wirkungsgrad der Wärmeabgabe des Resistors an das zu bedruckende Papier noch erhöht wird. Dadurch kann nochmals die Verlustleistung des Resistors vermindert werden.

In weiterer vorteilhafter Ausgestaltung können die Resistoren innerhalb der sie tragenden Isolierschicht eingebettet sein, wobei die plane Oberfläche der Resistoren und die plane Oberfläche der Isolierschicht in derselben Ebene liegen. Beim Druckvorgang wird dadurch in vorteilhafter Weise die Resistorschicht an ihren Rändern nicht abgenützt, so daß eine Kantenabschrägung der Resistoren nicht erfolgt. Dadurch wird die Lebensdauer der Resistorschicht entscheidend verlängert. Als weiterer Vorteil ist es deshalb nicht notwendig, die Resistorschicht mit einer weiteren Isolierschicht gegen mechanische Beeinflussung zu schützen. Auch durch die Möglichkeit des Weglassens der Isolierschicht auf der Resistorschicht wird der Wirkungsgrad der Wärmeabgabe der Resistorschicht an das Papier nochmals erhöht.

Aufgrund des erfindungsgemäßen Verfahrens ist es nunmehr möglich, die Resistoren in Form von flachen Mesas mit umlaufenden Stufen aufzubauen, wobei die Stufen von der Isolierschicht überlappt werden könnnen oder auch frei bleiben, so daß zwischen der Isolierschicht und der

„ürfel- oder quaderförmigen Konfiguration des Resistors ein Luftspalt besteht. Dadurch wird die entstehende Wärme unter völlig gleichmäßiger Verteilung im Resistor nach oben zum Papier hin auf dieses abgegeben. Dadurch wiederum wird erreicht, daß die gesamte Oberfläche des Resistors gleichzeitig druckt, so daß auch der Druckvorgang mit einer erfindungsgemäß hergestellten Thermoplatine beschleunigt wird.

Generell können somit mit dem erfindungsgemäßen Verfahren beliebige Hybrid-Schaltungen aufgebaut werden, wobei beliebige Dickfilm-Leiterschichten in beliebiger Anzahl oberhalb des Substrats angeordnet sein können. Erfindungsgemäß ist es möglich, die technologischen Daten des Substrats und der Substrats-Oberfläche, wie Parallelität, Geometrie, Oberflächenwelligkeit, Oberflächenrauhigkeit oder Dicke, in einer beliebigen Isolierschicht oberhalb des Substrats zu reproduzieren oder sogar zu verbessern, so daß die dergestalt bearbeitete Oberfläche der betreffenden Isolierschicht wiederum als Ausgangs-Oberfläche zur Aufbringung einer weiteren gedruckten Schaltung dienen kann. Die Ausgangseigenschaften des Substrats oder der Substrats-Oberfläche, die heute bestens zum Aufbringen einer gedruckten Schaltung geeignet sind, werden somit in beliebiger Höhe auf einer Isolierschicht reproduziert.

Das ist nur möglich aufgrund der hohen Maßhaltigkeit, mit der die Bearbeitung der Isolierschicht oder der Isolierschichten und somit die Reproduktion der technologischen Daten erfolgt. Die entsprechenden Dickfilm-Leiterschichten sowie die Isolierschichten lassen sich beliebig mechanisch bearbeiten, beispielsweise durch Sägen, Sandstrahlen, Laser-Schneidtechnik oder durch chemisch Ätzen. Sowohl die Isolierschichten als auch die Dickfilm-Leiterschichten können dergestalt bearbeitet werden, wobei ein absolutes Maß der Schichtdicke oder der Schichtdicken, bezogen beispielsweise auf die Substrats-Oberfläche, eingehalten werden kann. Dadurch ist in vorteilhafter Weise eine frei Wahl der geometrischen Anordnungen der elektronischen Elemente und/ oder Schaltungen auf den verschiedenen Isolierschichten möglich, die deshalb in Feinlinientechnik auf die Oberflächen aufdruckbar sind.

Bei der Anwendung des erfindungsgemäßen Verfahrens zur Herstellung von Thermoplatinen wird dadurch der geringste Andruck der Thermoplatine an das Papier bei minimalster Heizung erreicht, weil die einzelnen Punkte des Resistors mit geringster Wärmeverteilung arbeitet. Dadurch wird eine bis jetzt noch nicht erzielte Druckqualität erreicht und ebenfalls eine Beschleunigung des Druckvorganges.

Da die Resistorschicht nicht mehr direkt auf der Substrats-Oberfläche angeordnet ist, kann eine Isolierung der Resistorschicht zur Substrats-Oberfläche erfolgen, weshalb eine derart hergestellte Thermoplatine praktisch keine Wärmeverluste mehr besitzt.

Das erfindungsgemäße Verfahren ermöglicht auch einen optimierten Schaltungsaufbau.

Das erfindungsgemäße Verfahren ermöglicht somit zum ersten Mal bei der Herstellung von elektronischen Schaltelementen in Multilayer Thick Film Technology die Zwischenschaltung von die Oberfläche einer Schicht abtragende Bearbeitungsverfahren auf beliebigen Zwischenschichten, wodurch bewikt wird, daß auf der Oberfläche dieser abtragend bearbeiteten Schicht mindestens die gleichen Ausgangswerte für einen folgenden Druckvorgang vorhanden sind, die beim ersten Druckvorgang auf das Substrat vorhanden gewesen sind, wobei die abtragende Bearbeitung nicht auf Isolierschichten allein beschränkt ist.

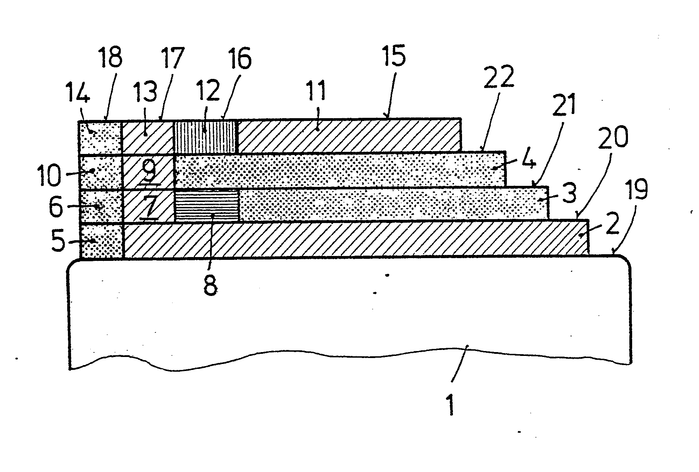

1. Ein Beispiel der Erfindung ist in der Zeichnung dargestellt und anschließend beschrieben:

Auf ein Substrat , welches vorzugsweise aus Aluminiumoxyd oder Prozellan besteht, ist eine Dickfilm-Leiterschicht 2 aufgebracht, vorzugsweise aufgedruckt und anschließend wärmebehandelt. Die Oberfläche 19 des Substrates 1 ist völlig plan gearbeitet.

Die Oberfläche 20 dieser Dickfilm-Leiterschicht 2 wird nun mechanisch oder chemisch abtragend bearbeitet, bis die Oberflächendaten hinsichtlich der Oberflächenwelligkeit und -rauhigkeit und Planparallelität mindestens den Werten der Oberflächengüte der Oberfläche 19 des Substrates 1 entspricht. Nunmehr ist auf diese Dickfilm-Leiterschicht 2 eine weitere Dickfilmleiterschicht 7 aufgebracht, um beispielsweise eine Leiterbahn nach oben zu ziehen. Diese Dickfilm-Leiterschicht 7 kann in ihren Abmessungen klein gehalten sein, wie aus der Zeichnung hervorgeht, um eben eine Stromführung zur Oberfläche des elektronischen Schaltelementes sicherzustellen. Gleichzeitig ist auf die Oberfläche 20 der Dickfilm-Leiterschicht 2 eine Isolierschicht 3 aufgebracht, die somit mit der Dickfilm-Leiterschicht 7 in einer Ebene liegt. Nunmehr wird die Oberfläche 21 dieser Isolierschicht 3 wiederum mechanisch oder chemisch abtragend bearbeitet, bis die Oberflächengüte hinsichtlich ihrer Daten wiederum mindestens der Oberflächengüte der Oberfläche 19 des Substrates 1 entspricht. Gleichzeitig wird dabei natürlich auch die Oberfläche der Dickfilm-Leiterschicht 7 bearbeitet.

Auf die dergestalt erfindungsgemäß bearbeitete Oberfläche 21 der Isolierschicht 3 ist nun eine weitere Isolierschicht 4 aufgebracht. Ebenso ist auf die Dickfilm-Leiterschicht 7 eine weitere Dickfilm-Leiterschicht 9 aufgebracht, wiederum vorzugsweise aufgedruckt gemäß den Verfahren der Dickfilmtechnik. Anschließend wird diese Oberfläche 22 der Isolierschicht 4 - natürlich auch die OBerfläche der Dickfilm-Leiterschicht 9 - wiederum mechanisch oder chemisch abtragend bearbeitet, bis wiederum die Oberflächengüte der Oberfläche 22 mindestens die Werte auffasst, wie die Oberfläche 19 des Substrates 1.

Anschließend ist auf diese Isolierschicht 4 eine weitere Dickfilm-Leiterschicht 12 aufgebracht, vorzugsweise in Dickfilmtechnik. Gleichzeitig ist auf die Oberfläche der Dickfilm-Leiterschicht 9 eine weitere Dickfilm-Leiterschicht 13 aufgebracht, so daß somit eine Strombahn von der untersten Dickfilm-Leiterschicht 2 über die Dickfilm-Leiterschichten 7 und 9 zur Dickfilm-Leiterschicht 13 und zur Dickfilm-Leiterschicht 12 geschaffen ist. In dem in der Figur gezeigten Beispiel ist eine Thermo-Druckplatine gezeigt, weshalb die oberste Dickfilm-Leiterschicht 12 eine Resistorschicht bzw. ein einzelner Resistor ist. Deshalb ist nunmehr auf die Oberfläche 22 der Isolierschicht 4 eine weitere Dickfilm-Leiterschicht 11 aufgebracht, die hier zur Stromableitung dient. Somit ist der Resistor 12 von zwei Seiten mittels Dickfilm-Leiterschichten 13, 11 kontaktiert, wobei die Dickfilm-Leiterschicht 13 die Zuführungs-, die Dickfilm-Leiterschicht 11 die Ableitungsleitung für den durch den Resistor 12 fließenden elektrischen Strom darstellt.

Auch die Oberfläche 15 der Dickfilm-Leiterschicht 11 und die Oberfläche 16 des Resistors 12 sowie die Oberfläche 17 der Dickfilm-Leiterschicht 13 kann nochmals mechanisch oder chemisch bearbeitet werden, bis wiederum eine hohe Oberflächengüte erreicht ist.

Zur Isolierung sind die Dickfilm-Leiterschichten 2, 7, 9 und 13 seitlich mit Isolierschichten 5, 6, 10 und 14 versehen, wobei somit diese Isolierschichten bis zur obersten Oberfläche der Thermodruckplatine hochgezogen sind.

Des weiteren ist in dem gezeigten Beispiel unterhalb der Resistor-schicht 12 eine die Wärmestrahlung derselben reflektierende Schicht 8 aufgebracht. Diese Schicht 8 dient dazu, die von der Resistorschicht 12 nach unten zum Substrat 1 hin abgestrahlte Wäremestrahlung wiederum nach oben zur Resistor-schicht hin zu reflektieren.

Nach dem erfindungsgemäßen Verfahren können praktisch eine beliebige Vielzahl derartiger Schichten in wechselnder Folge von Dickfilm-Leiterschichten und Isolierschichten auf ein Substrat aufgebracht werden, ohne daß die Druckgenauigkeit beim Aufdrucken der Dickfilm-Leiterschichten abnimmt. Deshalb wird beispielsweise bei der Anwendung des Verfahrens auf eine Thermo-Druckplatine erreicht, daß tatsächlich nach dem letzten Arbeitsgang alle einzelnen Resistoren (12) in einer Ebene liegen, wobei die Oberfläche dieser Resistorenschicht mindestens die Oberflächenwerte aufweist, wie die Oberfläche des Substrates.

Nach dem erfindungsgemäßen Verfahren, daß sich eine Vielzahl beliebiger elektronischer Schaltelemente und/oder Schaltungen herstellen, die in Vielschicht-Dickfilmtechnik hergestellt sind.

Die Abtragung der Oberflächen der einzelnen Schichten geschieht vorzugsweise mechanisch durch Schleifen, Sägen, Honen, Läppen oder Fräsen. Ebenfalls kann die Oberfläche der einzelnen Schichten bevorzugt mittels Laserstrahlen abgetragen und bearbeitet werden.

erfindungsgemäß/.
Die Genauigkeit der Abtragung geschiet mindestens unterhalb einer Welligkeit kleiner als fünf Mikron ( $5 \times 10^{-6}$ m). Bevorzugt geschiet die Abtragung bis zu einer Welligkeit von $\pm 1$ Mikron( $\pm$ ein $10^{-6}$ m). Die Welligkeit ist dabei bezogen auf eine absolut gerade Linie längs des Substrates, vorzugsweise längs der Längsachse des Substrates bzw. der Schaltelemente. Bei der Herstellung von Thermodruckplatinen mit in Reihe angeordneten Resistoren wird die Welligkeit auf eine gerade Linie längs der Resistoren bezogen, sodaß zweckmäßig die oberste Oberfläche der Resistoren eine Welligkeit von $\pm 1$ Mikron einhält.

Patentansprüche:

1. Verfahren zur Herstellung elektronischer Schaltelemente und/oder Schaltungen in Vielschicht-Dickfilmtechnik (Multilayer Thick Film Technology) auf einem Substrat, insbesondere Aluminiumoxid oder Porzellan, wobei die elektronischen Schaltelemente und/oder Schaltungen in Form von flüssigen oder pastösen Materialien-Mischungen auf das Substrat aufgedruckt und anschließend wärmebehandelt werden (Dickfilm-Leiterschicht) und danach mindestens eine Isolierschicht auf die Dickfilm-Leiterschicht aufgebracht wird,
dadurch gekennzeichnet,
daß eine beliebige Isolier-Zwischenschicht oder beliebige Isolier-Zwischenschichten bezüglich ihrer Oberfläche abtragend bearbeitet werden und anschließend auf diese bearbeitete Oberfläche wiederum mindestens eine Dickfilm-Leiterschicht und/oder mindestens eine Isolierschicht aufgebracht wird, deren Oberfläche bei weiterfolgenden Druckvorgängen von Dickfilmleiterschichten oder bei weiteren Isolierschichten wiederum abtragend bearbeitet wird, um nach Abschluß jeder Schicht mindestens die Weiterverarbeitungsgrundlagen und -voraussetzungen wie auf dem Substrat zu schaffen.

2. Verfahren nach Anspruch 1,
dadurch gekennzeichnet,
daß die Oberfläche der Isolierschichten und ggf. die Dickfilm-Leiterschicht der letzten Lage mechanisch oder chemisch abtragend bearbeitet werden unterhalb einer Welligkeit von fünf Mikron (5x $10^{-6}$m), vorzugsweise $\pm$ 1 Mikron, bezogen auf eine gerade Linie längs der Längsachse des Substrates bzw. längs der Orientierung der Schaltelemente.

3. Verfahren nach Anspruch 2, dadurch gekennzeichnet,
daß die Oberflächen der Schichten mechanisch durch Schleifen, Sägen, Honen, Läppen oder Fräsen abgetragen werden.

4. Verfahren nach Anspruch 1 zum Herstellen von Thermoplatinen, insbesondere für thermoelektrische Drucker, dadurch gekennzeichnet,
daß auf die oberste nach Maß bearbeitete Isolierschicht eine Dickfilm-Widerstandsschicht aufgebracht und diese getrimmt wird.

5. Elektronisches Schaltelement und/oder Schaltung in Vielschicht-Dickfilmtechnik, vorzugsweise Thermodruckplatine, nach den Ansprüchen 1 und 4, dadurch gekennzeichnet,
daß auf dem Substrat (1) verschiedene nach Maß bearbeitete Dickfilm-Leiterschichten (2, 7, 9, 11, 13) und Isolierschichten (3, 4, 5, 6, 10, 14) mit hoher Maßhaltigkeit angeordnet sind und auf der obersten Isolierschicht (4) eine Dickfilm-Widerstandsschicht (12) aufgebracht und in einzelne Widerstände (12) unterteilt ist.

6. Thermoplatine nach den Ansprüchen 4 oder 5, dadurch gekennzeichnet,
daß auf das Substrat (1) oder als Zwischenschicht auf eine folgende Isolierschicht oder eine Dickfilm-Leiterschicht (2) unterhalb der Dickfilm-Widerstandsschicht (12) eine die Wärmestrahlung derselben reflektierende Schicht (8) aufgebracht ist.

7. Thermoplatine nach den Ansprüchen 5 und 6, dadurch gekennzeichnet,
daß die Widerstände (12) mindestens auf zwei sich gegenüberliegenden Seiten in die Isolierschicht (14) eingebettet sind und die planen Oberflächen (16, 18) der Widerstände (12) und der Isolierschicht (14) in derselben Ebene liegen.

8. Thermoplatine nach Anspruch 9, dadurch gekennzeichnet, daß die einzelnen Widerstände mesaförmig mit umlaufender Stufe ausgebildet sind, wobei die Isolierschicht die Stufen überlappt.

9. Thermoplatine nach Anspruch 7, dadurch gekennzeichnet, daß zwischen den Widerständen und der Isolierschicht ein Luftspalt angeordnet ist.

10. Thermoplatine nach den Ansprüchen 2 und 4, dadurch gekennzeichnet, daß die Widerstandsschicht zur Trimmung in ihrer Dicke abgetragen ist ohne Veränderung der geometrischen Konfiguration der Widerstandsschicht oder der einzelnen Widerstände und daß die Widerstandsschicht mittels Laserstrahlen getrimmt ist.